# EUROPEAN PATENT APPLICATION

(11) **EP 4 343 845 A1**
(43) Date of publication of application: **27.03.2024**
(21) Application number: 22849718.6
(22) Date of filing: 16.06.2022
(51) Int. Cl.: H01L 27/15, H01L 33/48, H01L 33/60, H01L 33/50, H01L 33/00

(54) **DISPLAY MODULE AND WEARABLE ELECTRONIC DEVICE COMPRISING SAME**

(30) Priority: 27.07.2021 KR 20210098835; 13.10.2021 KR 20210136070
(71) Applicant: Samsung Electronics Co., Ltd., Suwon-si, Gyeonggi-do 16677 (KR)
(72) Inventor: KIM, Nari, Suwon-si Gyeonggi-do 16677 (KR); PARK, Kyongtae, Suwon-si Gyeonggi-do 16677 (KR); JUNG, Taeil, Suwon-si Gyeonggi-do 16677 (KR); JUNG, Hoyoung, Suwon-si Gyeonggi-do 16677 (KR)
(74) Representative: Appleyard Lees IP LLP
(86) International application number: PCT/KR2022/008564
(87) International publication number: WO 2023/008739

(57) **Abstract**

Disclosed are a display module and a wearable electronic device comprising same. The disclosed display module may comprise: a substrate; a plurality of light-emitting device units arranged on the substrate; barrier ribs extending from the plurality of light-emitting device units and partitioning sub-pixel regions; a color conversion layer disposed on the plurality of light-emitting device units and emitting excitation light by means of light emitted from the plurality of light-emitting device units; a common electrode including a metal layer that is disposed, as a portion of the plurality of light-emitting device units, on upper portions of the plurality of light-emitting device units that connect the respective light-emitting device units and inside the barrier ribs to be in contact with the upper portions of the plurality of light-emitting device units; and a plurality of individual electrodes that are respectively disposed on opposite surfaces of light-emitting surfaces of the plurality of light-emitting device units. Various other embodiments are possible.

## Description

### [Technical Field]

The disclosure relates to a display module and a wearable device including the same.

### [Background Art]

An electronic device for a portability purpose generally includes a flat type display device and a battery, and has a bar type, a folder type, and a sliding type appearance. Recently, as electronic communication technology is developed, an electronic device is miniaturized so that a wearable electronic device that may be worn on a part of a human body such as a wrist or a head has been commercialized.

A wearable electronic device has a shape such as a watch or glasses, thus is portable, and various functions such as a mobile communication terminal are incorporated inside the miniaturized device, thereby satisfying consumer's needs.

### [Disclosure of Invention]

### [Technical Problem]

Various embodiments of the disclosure may provide a wearable electronic device including a display module capable of stably supplying a current applied to each sub-pixel.

### [Solution to Problem]

A display module according to various example embodiments of the disclosure may include: a substrate; a plurality of light-emitting device units arranged on the substrate; barrier ribs extending from the plurality of light-emitting device units and partitioning sub-pixel regions; a color conversion layer disposed on an upper portion of the plurality of light-emitting device units and configured to emit excitation light via light emitted from the plurality of light-emitting device units; a common electrode including a metal layer disposed, as a portion of the plurality of light-emitting device units, on upper portions of the plurality of light-emitting device units connecting the respective light-emitting device units and inside the barrier ribs to be in contact with the upper portions of the plurality of light-emitting device units; and a plurality of individual electrodes respectively disposed on opposite surfaces of light-emitting surfaces of the plurality of light-emitting device units.

A wearable device according to various example embodiments of the disclosure may include: a display module comprising a substrate and a plurality of sub-pixels arranged on the substrate; a projection lens configured to concentrate light emitted from the display module; and a diffraction optical member that introduces light emitted from the projection lens at one side and to emit the light to another side, and the plurality of subpixels may include a plurality of light-emitting device units, barrier ribs extending from the plurality of light-emitting device units and partitioning sub-pixel regions, an optical layer and a color conversion layer disposed between the barrier ribs, a plurality of color filter layers disposed on an upper portion of the color conversion layer and an upper portion of the optical layer, a black matrix partitioning the plurality of color filter layers, a plurality of microlenses disposed on an upper surface of the plurality of color filter layers, a common electrode including a metal layer disposed, as a portion of the plurality of light-emitting device units, on upper portions of the plurality of light-emitting device units connecting the respective light-emitting device units and inside the barrier ribs to be in contact with the upper portions of the plurality of light-emitting device units, and a plurality of individual electrodes respectively disposed on opposite surfaces of light-emitting surfaces of the plurality of light-emitting device units.

According to various example embodiments of the disclosure, since a common electrode including a portion of a plurality of light-emitting device units and a metal layer disposed inside the barrier ribs and having an approximately grating shape with respect to the entire region of the display module is included, current may be stably applied to each of the sub-pixels and thus, display uniformity may be significantly improved.

Also, a display module according to various example embodiments of the disclosure may increase work efficiency and improve manufacturing precision since barrier ribs are not stacked between sub-pixels through a separate process.

### [Brief Description of Drawings]

FIG. 1 is a block diagram of a wearable electronic device in a network environment according to various embodiments of the disclosure.
FIG. 2 is a schematic diagram illustrating a structure of a wearable electronic device according to an embodiment of the disclosure.
FIG. 3 is a cross-sectional view illustrating a pixel structure of a display module according to an embodiment of the disclosure.
FIG. 4 is a diagram illustrating an example in which the barrier ribs and the metal layer of the display module according to an embodiment are arranged in a grating arrangement.
FIG. 5 is a flowchart schematically illustrating a method of manufacturing a display module according to an embodiment of the disclosure.
FIGS. 6A to 6L are diagrams illustrating processes of manufacturing a display module according to an embodiment of the disclosure.
FIG. 7 is a cross-sectional view illustrating a pixel structure of a display module according to another embodiment of the disclosure.
FIG. 8 is a cross-sectional view illustrating a pixel structure of a display module according to another embodiment of the disclosure.
FIGS. 9A to 9D are diagrams illustrating processes of manufacturing a display module according to another embodiment of the disclosure.
FIG. 10 is a cross-sectional view illustrating a pixel structure of a display module according to another embodiment of the disclosure.
FIGS. 11A to 11D are diagrams illustrating processes of manufacturing a display module according to another embodiment of the disclosure.
FIG. 12 is a cross-sectional view illustrating a pixel structure of a display module according to another embodiment of the disclosure.

### [Mode for Invention]

The terms used in the disclosure will be briefly explained, and various example embodiments will be described in greater detail with reference to the accompanying drawings. In describing the disclosure, a detailed description of a related known technology may be omitted, and a duplicate description of the same configuration may be omitted.

Terms used in the disclosure are selected as general terminologies currently widely used in consideration of the configuration and functions of the disclosure, but can be different depending on intention of those skilled in the art, a precedent, appearance of new technologies, or the like. Further, in specific cases, terms may be arbitrarily selected. In this case, the meaning of the terms will be described in the description of the corresponding embodiments. Accordingly, the terms used in the description should not necessarily be construed as simple names of the terms, but be defined based on meanings of the terms and overall contents of the disclosure.

The example embodiments may vary, and may be provided in different example embodiments. Various example embodiments will be described with reference to accompanying drawings. However, this does not necessarily limit the scope of the example embodiments to a specific embodiment form. Instead, various modifications, equivalents and replacements included in the disclosed concept and technical scope of this disclosure may be employed. While describing example embodiments, if it is determined that the specific description regarding a known technology obscures the gist of the disclosure, the specific description may be omitted.

The term such as "first" and "second" used in various example embodiments may modify refer to elements regardless of an order and/or importance of the corresponding elements, and does not limit the corresponding elements. The terms are simply used to differentiate one component from other components. For example, the 'first' component may be named the 'second' component, and vice versa, without departing from the scope of the disclosure.

Singular forms are intended to include plural forms unless the context clearly indicates otherwise. The terms "include", "comprise", "is configured to," etc., of the description are used to indicate that there are features, numbers, steps, operations, elements, parts or combination thereof, and they should not exclude the possibilities of combination or addition of one or more features, numbers, steps, operations, elements, parts or a combination thereof.

In the disclosure, a 'module' or a 'unit' performs at least one function or operation and may be implemented by hardware or software or a combination of the hardware and the software. In addition, a plurality of 'modules' or 'units' may be integrated into at least one module and may be realized as at least one processor in an integrated manner except for 'modules' or 'units' that should be realized in specific hardware.

Hereinbelow, the disclosure will be described in detail with reference to the accompanying drawings so that those skilled in the art to which the disclosure belongs may easily practice the embodiment. However, the disclosure may be implemented in various different forms and is not limited to the example embodiments described herein. In addition, in order to clearly describe the disclosure, portions not related to the description may be omitted, and like reference numerals are assigned to similar parts throughout the disclosure.

Furthermore, various example embodiments of the disclosure are described in greater detail with reference to the accompanying drawings and the contents disclosed in the accompanying drawings, but the disclosure is not limited or restricted by the embodiments.

Hereinbelow, with reference to the drawings, a wearable electronic device according to various example embodiments of the disclosure will be described in detail.

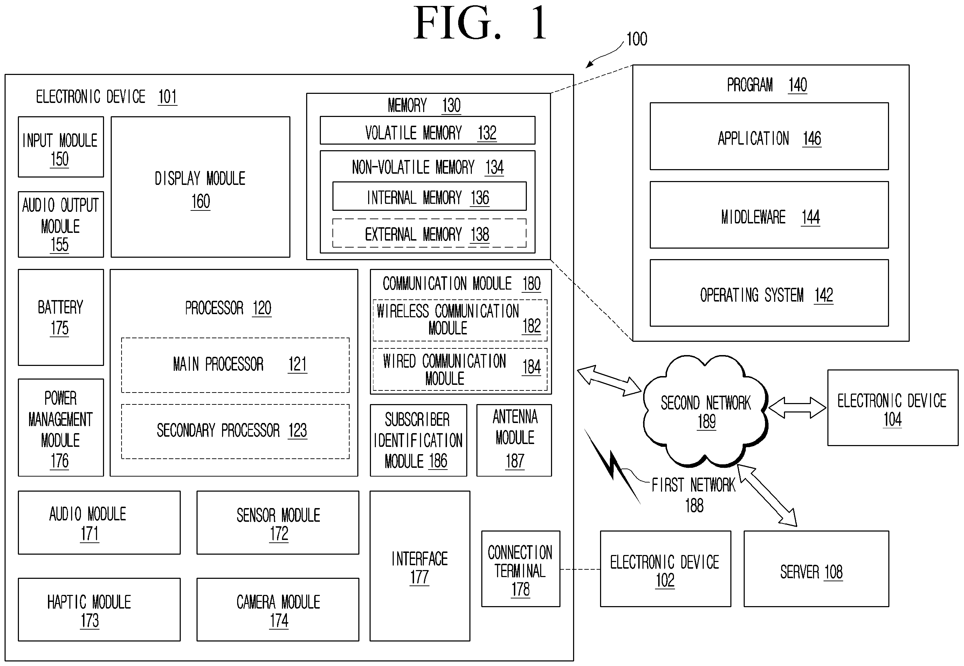

FIG. 1 is a block diagram of a wearable electronic device in a network environment according to various embodiments of the disclosure. For reference, although a device according to various embodiments of the disclosure is referred to as an "electronic device" for convenience of description, the device of various embodiments may be an electronic device, a wireless communication device, a display device, or a portable communication device.

Referring to FIG. 1, a wearable device 101 in a network environment 100 may communicate with an electronic device 102 via a first network 188 (e.g., a short-range wireless communication network) or communicate with an electronic device 104 or a server 108 via a second network 189 (e.g., wide area network). According to an embodiment, the wearable electronic device 101 may communicate with the electronic device 104 via the server 108. According to an embodiment, the wearable electronic device 101 may include a processor 120, a memory 130, an input module 150, an audio output module 155, a display module 160, an audio module 171, a sensor module 172, a haptic module 173, a camera module 174, a battery 175, a power management module 176, an interface 177, a connection terminal 178, a communication module 180, a subscriber identification module 186, or an antenna module 187.

In various embodiments, at least one (e.g., a connection terminal 178) of the components may be omitted from the wearable electronic device 101, or one or more other components may be added to the wearable electronic device 101. In various embodiments, some of the components (e.g., the sensor module 172, the camera module 174, or the antenna module 187) may be integrated into one component (e.g., the display module 160).

According to an embodiment, the wearable electronic device 101 may display various images. The image may refer, for example, to a concept including a still image and a moving image, and the wearable electronic device 101 may display various images such as broadcast content, multimedia content, and the like. In addition, the wearable electronic device 101 may display a user interface (UI) and an icon. For example, the display module 160 may include a display deriver IC (not shown) and may display an image based on an image signal received from the processor 120. For example, the display driver IC may generate a drive signal for a plurality of sub-pixels based on an image signal received from the processor 120, and display an image by controlling light emission of the plurality of sub-pixels based on the drive signal.

According to an embodiment, the processor 120 may control the overall operation of the wearable electronic device 101. The processor 120 may be configured with one or multiple processors. For example, the processor 120 may perform an operation of the wearable electronic device 101 according to various embodiments of the disclosure by executing at least one instruction stored in the memory.

According to an embodiment, the processor 120 may be implemented by a digital signal processor (DSP) that processes a digital image signal, a microprocessor, a GPU, an artificial intelligence (AI) processor, a neural processing unit (NPU), or a time controller (TCON). However, the processor 120 is not limited thereto, and may include one or more of a central processing unit (CPU), a micro controller unit (MCU), a micro processing unit (MPU), a controller, an application processor (AP), a communication processor (CP), and an advanced reduced instruction set computer (RISC) machine (ARM) processor, or may be defined by these terms. In addition, the processor 120 may be implemented by a system-on-chip (SoC) or a large scale integration (LSI) in which a processing algorithm is embedded or may be implemented in the form of an application specific integrated circuit (ASIC) or a field programmable gate array (FPGA).

According to an embodiment, the processor 120 may drive an operating system or an application program to control hardware or software components connected to the processor 120, and may perform various types of data processing and computation. In addition, the processor 120 may load and process a command or data received from at least one of other components into a volatile memory, and store various data in a non-volatile memory.

According to an embodiment, the processor 120 may control the at least one another component (e.g., hardware or software component) of the wearable electronic device 101 connected to the processor 120 by executing the software (e.g., the program 140) and perform various data processing or operation. According to an embodiment, as at least a part of the data processing or operation, the processor 120 may store the command or data received from another component (e.g., the sensor module 172 or the communication module 180) to a volatile memory 132, process command or data stored in the volatile memory 132, and store the result data in a non-volatile memory 134. According to an embodiment, the processor 120 may include a main processor 121 (e.g., a central processing unit or an application processor), and a secondary processor 123 (e.g., a graphics processing unit, a neural processing unit (NPU), an image signal processor, a sensor hub processor, or a communication processor) which may be operated together or independently. For example, when the wearable electronic device 101 includes the main processor 121 and the secondary processor 123, the secondary processor 123 may use less power than the main processor 121, or may be set to be specialized to a designated function. The secondary processor 123 may be implemented separately from, or as a part of, the main processor 121.

According to an embodiment, the secondary processor 123 may, for example, in place of the main processor 121 while the main processor 121 is in an inactive state (for example: sleep) or along with the main processor 121 while the main processor 121 is in an active state (for example: execution of an application) control a part of the functions or states related to at least one component (for example: display module 160, the sensor module 172, or the communication module 180) among the components of the electronic device 101. According to an embodiment, the secondary processor 123 (e.g., an image signal processor or a communication processor) may be implemented as a part of a functionally related other components (e.g., camera module 174 or communication module 180). According to an embodiment, the secondary processor 123 (e.g., a neural network processing device) may include a hardware structure specialized for processing an artificial intelligence model. The artificial intelligence model may be generated through machine learning. The learning may be performed by, for example, an electronic device 101 in which an artificial intelligence model is performed, and may be performed through a separate server (for example, the server 108). The learning algorithm may include, for example, supervised learning, unsupervised learning, semi-supervised learning, or reinforcement learning, but is not limited to the above-described example. The artificial intelligence model may include a plurality of artificial neural network layers. The artificial neural network may be one of a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-networks, or a combination of two or more of the above. The artificial intelligence model may additionally or alternatively include a software structure in addition to the hardware structure.

According to an embodiment, the memory 130 may store various data used by at least one component (e.g., processor 120 or sensor module 172) of the wearable electronic device 101. The data may include, for example, software (e.g., program 140) and input data or output data related with software instructions. The memory 130 may include the volatile memory 132 or non-volatile memory 134.

According to an embodiment, the processor 120 may be stored in the memory 130 as software, and include, for example, an operating system 142, middleware 144, or an application 146.

According to an embodiment, the input module 150 may receive a command or data to be used by a component (e.g., the processor 120) of the wearable electronic device 101 from the outside (e.g., a user) of the wearable electronic device 101. The input module 150 may further include, for example, a microphone, a dome switch, a touch pad (a contact capacitive type, a pressure resistive type, an infrared sensing method, a surface ultrasonic conduction method, an integral tension measuring method, a piezo effect method, etc.), but is not limited thereto.

According to an embodiment, the sound output module 155 may output an acoustic signal to the outside of the wearable electronic device 101. The sound output module 155 may include, for example, a speaker or a receiver. The speaker may be used for general purposes, such as multimedia playback or recording playback. The receiver may be used to receive an incoming call. According to an embodiment, the receiver may be implemented as separate from, or as part of a speaker.

According to an embodiment, the display module 160 may visually provide information to the outside (e.g., a user) of the wearable electronic device 101. The display module 160 may include, for example, a display, a hologram device, or a projector and a control circuit for controlling a corresponding device.

According to an embodiment, the audio module 171 may convert a sound into an electrical signal or convert the electrical signal to sound. According to an embodiment, the audio module 171 may obtain a sound through the input module 150, or output the sound through the sound output module 155, or an external electronic device (e.g., an electronic device 102) (e.g., a speaker or a headphone) directly or wirelessly connected to or the wearable electronic device 101.

According to an embodiment, the sensor module 172 may detect an operation state (e.g., power or temperature) of the wearable electronic device 101 or an environmental state (e.g., a state of a user) external to the wearable electronic device 101, and generate an electrical signal or a data value corresponding to the detected state. According to an embodiment, the sensor module 172 may include, for example, a terrestrial magnetic sensor, an acceleration sensor, a location sensor, and a gyroscope sensor. In addition, sensors for detecting biological signals such as a user's biometric signal, for example, Electrocardiography (ECG), Galvanic skin reflex (GSR), pulse wave, and the like may be provided. In addition, various embodiments may further include a temperature sensor, a humidity sensor, an infrared sensor, an atmospheric pressure sensor, a proximity sensor, a magnetic sensor, a grip sensor, a color sensor, an illuminance sensor, and the like, but is not limited thereto.

According to an embodiment, the haptic module 173 may convert an electrical signal into a mechanical stimulus (e.g., a vibration or a movement) or an electrical stimulus which may be recognized by a user through tactile sensation or kinesthetic sensation. According to an embodiment, the haptic module 173 may include, for example, a motor, a piezoelectric element, or an electric stimulator.

According to an embodiment, the camera module 174 may capture a still image and a moving image. According to an embodiment, the camera module 174 may include one or more lenses, image sensors, image signal processors, or flashes.

According to an embodiment, the power management module 176 may manage power supplied to the wearable electronic device 101. According to an embodiment, the power management module 176 may be implemented as at least part of, for example, a power management integrated circuit (PMIC).

According to an embodiment, the battery 175 may supply power to at least one component of the electronic device 101. According to an embodiment, the battery 175 may include, for example, a primary cell which is not rechargeable, a secondary cell which is rechargeable, or a fuel cell.

According to an embodiment, the interface 177 may support one or more specified protocols to be used for the wearable electronic device 101 to be connected to the external electronic device (e.g., the electronic device 102) directly or wirelessly.

According to an embodiment, the connection terminal 178 may include a connector through which the wearable electronic device 101 may be physically connected to an external electronic device (e.g., the electronic device 102).

According to an embodiment, the communication module 180 may support establishment of direct (e.g.: wired) communication channel between the electronic device 101 and an external electronic device (e.g., electronic device 102, electronic device 104, or server 108) or wireless communication channel, and communication through the established communication channels. The communication module 180 may include one or more communication processors which are operated independently of the processor 120 (e.g., application processor) and support direct (e.g., wired) communication or wireless communication. According to an embodiment, the communication module 180 may include a wireless communication module 182 (e.g., cellular communication module, near field wireless communication module, or global navigation satellite system (GNSS) communication module) or wired communication module 184 (e.g., local area network (LAN) communication module, or power line communication module). The corresponding communication module among these communication modules may communicate with an external electronic device 104 via the first network 188 (e.g., Bluetooth, WiFi direct or near field communication network such as infrared data association (IrDA)) or the second network 189 (e.g., legacy cellular network, 5G network, next generation communication network, Internet, or computer network (e.g., LAN or WAN)). These types of communication modules may be incorporated into one component (e.g., a single chip) or implemented with a plurality of components (e.g., a plurality of chips) that are separate from each other. The wireless communication module 182 may confirm and authenticate the wearable electronic device 101 in the communication network such as the first network 188 or the second network 189 using the subscriber information (e.g., international mobile subscriber identity (IMSI)) stored in the subscriber identification module 186.

According to an embodiment, the wireless communication module 182 may support a 5G network after a 4G network and a next generation communication technology, for example, a new radio (NR) access technology. The NR access technology may support highspeed data transmission (enhanced mobile broadband (eMBB)) of high-capacity data, minimization/reduction of terminal power, massive machine type communications (mMTC), or ultra-reliable and low-latency communications (URLLC). The wireless communication module 182 may support, for example, a high frequency band (e.g., an mmWave band) for achieving a high data transmission rate. The wireless communication module 182 may support various technologies for ensuring performance in a high-frequency band, for example, beamforming, massive multiple-input and multiple-output (MIMO), full dimensional MIMO (FD-MIMO), array antenna, analog beam-forming, or large scale antenna. The wireless communication module 182 may support various requirements specified in the wearable electronic device 101, an external electronic device (e.g., the electronic device 104), or a network system (e.g., the second network 189). According to an embodiment, the wireless communication module 182 may support a peak efficient data rate (for example, 20 Gbps or more) for eMBB realization, a loss coverage specification (for example, 164 dB or less) for realization of mMTC, or U-plane latency (e.g., 0.5 ms or less for down link (DL) and uplink (UL), or round trip 1 ms or less) for URLLC realization.

According to an embodiment, the antenna module 187 may transmit a signal or power to an external device (e.g., an external electronic device) or receive a signal or power from the outside. According to an embodiment, the antenna module 187 may include one or more antennas (e.g., array antenna), and at least one antenna suitable for a communication method used in a communication network, such as the first network 188 or the second network 189, may be selected from the one or more antennas by, for example, the communication module 180.

According to an embodiment, the antenna module 187 may include a plurality of antennas (e.g., an array antenna), and according to an embodiment, the antenna module 187 may include an antenna including a radiator including a conductive pattern or a conductor formed on a substrate (e.g., PCB).

According to an embodiment, the antenna module 187 may form an mmWave antenna module. According to an embodiment, the mmWave antenna module may include a printed circuit board; a radio frequency integrated circuit (RFIC) disposed on or adjacent to a first surface (e.g., a lower surface) of the printed circuit board and capable of supporting a designated high frequency band (e.g., an mmWave band); and a plurality of antennas (for example, an array antenna) disposed on or adjacent to a second surface (e.g., an upper surface or a side surface) of the printed circuit board and capable of transmitting or receiving a signal of the designated high frequency band.

A signal or power may be transmitted or received between the communication module 180 and an external electronic device via at least one antenna. According to an embodiment, another component (e.g., a radio frequency integrated circuit (RFIC)) other than the radiator may be additionally formed as a part of the antenna module 187.

At least a part of the components may be interconnected through the communication method (e.g., bus, general purpose input and output (GPIO), serial peripheral interface (SPI), or mobile industry processor interface (MIPI)) among peripheral devices and exchange a signal (e.g., command or data) from each other.

An instruction or data may be transmitted or received between the wearable electronic device 101 and the external electronic device 104 via the server 108 connected to the second network 189. Each of the external electronic devices 102, 104 may be a device of a same type as or a different type from the wearable electronic device 101. According to an embodiment, all or a part of operations to be executed at the wearable electronic device 101 may be executed by at least one external electronic device among external electronic devices 102, 104, or 108. For example, when the wearable electronic device 101 should perform any function or service automatically, or in response to a request from a user or another device, the wearable electronic device 101 may request the one or more external electronic devices to perform at least part of the function or the service, instead of, or in addition to, executing the function or the service by itself. The one or more external electronic devices receiving the request may execute at least a part of the function or the service requested, or an additional function or service related to the request, and transfer a result of the execution to the wearable electronic device 101. The wearable electronic device 101 may provide the result, with or without further processing of the result, as at least part of a response to the request. For this, for example, a cloud computing, distributed computing, mobile edge computing (MEC), or client-server computing technology may be used. The wearable electronic device 101, for example, may provide an ultra-low latency service using distributed computing or mobile edge computing. According to an embodiment, the external electronic device 104 may include an Internet of Things (IoT) device. The server 108 may be an intelligent server using machine learning and/or a neural network. According to an embodiment, the external electronic device 104 or the server 108 may be included in a second network 189. The wearable electronic device 101 may be applied to an intelligent service (for example, a smart home, a smart city, a smart car, or healthcare) based on the 5G communication technology and an IoT-related technology.

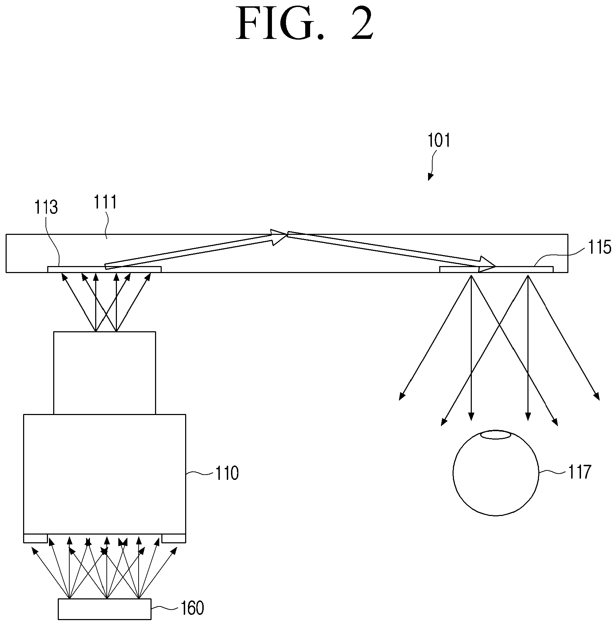

FIG. 2 is a schematic diagram illustrating a structure of a wearable electronic device according to an embodiment of the disclosure.

Referring to FIG. 2, the wearable electronic device 101 according to an embodiment may include a display module 160, a projection lens 110 on which light emitted from a plurality of light emitting elements mounted on the display module 160 is incident, and a diffraction optical member 111 to which the light concentrated by the projection lens 110 is incident.

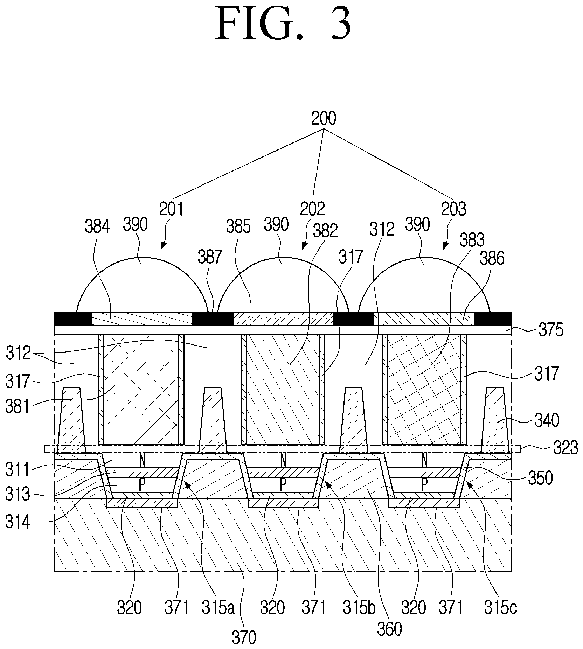

According to an embodiment, the light emitted from the display module 160 is concentrated through a microlens 390 (see FIG. 3), which will be described later, and is incident on the projection lens 110. The light incident on the projection lens 110 may be projected to the eyes of a user through the diffraction optical member 111.

According to an embodiment, the size of the display module 160 may be equal to or smaller than the size of the light incident surface of the projection lens 110. Light emitted from a plurality of light emitting elements of the display module 160 is incident into the projection lens 110 through the light incident surface of the projection lens 110.

According to an embodiment, the diffraction optical member 111 may include, for example, an optical waveguide including a transparent material (for example, glass). A first diffraction grating 113 and a second diffraction grating 115 may be disposed on one side and the other side of the diffraction optical member 111, respectively. The first diffraction grating 113 may be arranged to correspond to the emission surface of the projection lens 110, and the light emitted from the emission surface of the projection lens 110 may be incident into the diffraction optical member 111. The second diffraction grating 115 emits the light passing through the inside of the diffraction optical member 111 to the outside of the diffraction optical member 111. The second diffraction grating 115 may be disposed at a location at which light is emitted toward the eyes 117 of the user while the user is wearing the wearable electronic device 101 on the head of the user.

According to an embodiment, a sub-pixel structure 200 (see FIG. 3) provided in the display module 160 of the disclosure may concentrate light emitted from the light-emitting elements 315a, 315b, 315c (see FIG. 3) to a front surface without spreading widely. For example, most of the light emitted from each sub-pixel structure 200 of the display module 160 may be concentrated on the incident surface of the projection lens 110 without departing from the incident surface of the projection lens 110.

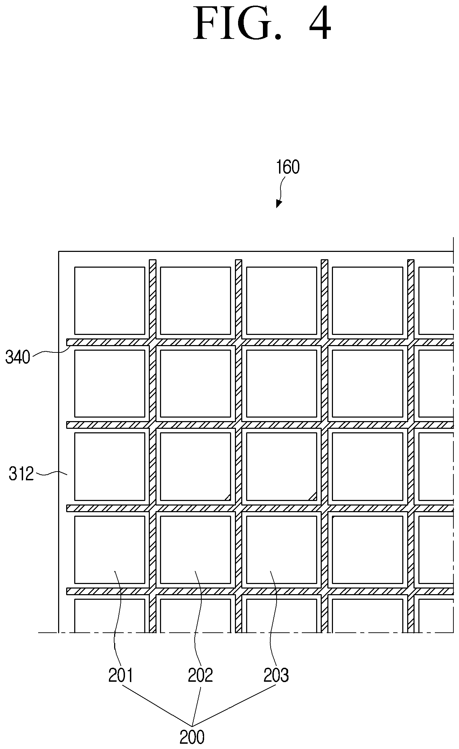

FIG. 3 is a cross-sectional view illustrating a pixel structure of a display module according to an embodiment of the disclosure, FIG. 4 is a diagram illustrating an example in which the barrier ribs and the metal layer of the display module according to an embodiment are arranged in a grating arrangement.

Referring to FIG.3, the display module 160 according to an embodiment of the disclosure may include a substrate 370, a plurality of sub-pixels 201, 202, 203 arranged on the substrate, and a micro-lens 390 for projecting light emitted from each of the sub-pixels 201, 202, 203 onto the light incident surface of the projection lens 110.

According to an embodiment, the substrate 370 comprises a transparent glass material (a main component is a SiO₂). However, the various embodiments are not limited thereto, and may be formed of a transparent or translucent polymer. In this case, the polymer may be an insulating organic material such as polyether sulfone (PES), polyimide (PI), polyethylene terephthalate (PET), polyethylene naphthalate (PEN), or polycarbonate (PC).

According to an embodiment, a plurality of thin film transistors (TFT, not shown) are provided to the substrate 370. In this this closure, the TFT is not limited to a particular structure or type, for example, the TFT of the disclosure may include a substrate that may be realized such as amorphous silicon (a-Si) TFT, low temperature polycrystalline silicon (LTPS) TFT, low temperature polycrystalline oxide (LTPO) TFT, hybrid oxide and polycrystalline silicon (HOP) TFT, liquid crystalline polymer (LCP) TFT, organic TFT (OTFT), or graphene TFT.

According to an embodiment, the substrate 370 may be arranged with a plurality of substrate electrode pads 371 to which individual electrodes 320 of light-emitting device units 315a, 315b, 315c, which will be described later, are electrically connected. The plurality of substrate electrode pads 371 may be electrically connected to a plurality of TFT circuits provided on the substrate 370.

According to an embodiment, one pixel 200 may include a plurality of sub-pixels 201, 202, 203 emitting light of different colors. Here, the reference numeral 201 may refer, for example, to a sub-pixel for emitting blue light, the reference numeral 202 may be a sub-pixel for emitting red light, and the reference numeral 203 may be a sub-pixel for emitting green light. For convenience of description, a plurality of sub-pixels 201, 202, and 203 may be referred to as a first sub-pixel 201, a second sub-pixel 202, and a third sub-pixel 203, respectively.

According to an embodiment, the first sub-pixel 201 may include a first light-emitting device unit 315a, the second sub-pixel 202 may include a second light-emitting device unit 315b, and the third sub-pixel 203 may include a third light-emitting device unit 315c. For example, the first sub-pixel 201 may emit light in a blue wavelength band, the second sub-pixel 202 may emit light in a red wavelength band, and the third sub-pixel 203 may emit light in a green wavelength band.

According to an embodiment, all of the first to third light-emitting device units 315a, 315b, 315c may emit light of the same color (for example, blue light). The first to third light-emitting device units 315a, 315b, and 315c may have the same structure, and hereinafter, only the structure of the first light-emitting device unit 315a will be described.

According to an embodiment, the first light-emitting device unit 315a may include a first semiconductor layer 311, a second semiconductor layer 314, an active layer 313 provided between the first semiconductor layer 311 and the second semiconductor layer 314.

According to an embodiment, the first semiconductor layer 311, the active layer 313, and the second semiconductor layer 314 may be formed using a method such as metal organic chemical vapor deposition (MOCVD), chemical vapor deposition (CVD), or plasma-enhanced chemical vapor deposition (PECVD).

According to an embodiment, the first semiconductor layer 311 may include, for example, an n-type semiconductor layer (cathode, reduction electrode). The n-type semiconductor layer may be selected from, for example, GaN, AlN, AlGaN, InGaN, InN, InAlGaN, AlInN, or the like, and may be doped with a n-type dopant such as Si, Ge, or Sn.

According to an embodiment, the first semiconductor layer 314 may include, for example, a p-type semiconductor layer (anode, oxide electrode). The p-type semiconductor layer may be selected from, for example, GaN, AlN, AlGaN, InGaN, InN, InAlGaN, AlInN, or the like, and may be doped with a p-type dopant such as Mg, Zn, Ca, Sr, or Ba.

Meanwhile, the light-emitting device unit 315a is not limited to the configuration described above, and for example, the first semiconductor layer 311 may include a p-type semiconductor layer, and the second semiconductor layer 314 may include an n-type semiconductor layer.

According to an embodiment, the active layer 313 is a region in which electrons and holes are recombined. The active layer 313 may transition to a low energy level by recombination of electrons and holes, and may generate light having a corresponding wavelength. The active layer 313 may include a semiconductor material such as amorphous silicon or poly crystalline silicon. Various embodiments are not limited thereto and may include an organic semiconductor material, and may be formed in a single quantum well (SQW) structure or a multi quantum well (MQW) structure.

According to an embodiment, the first to third light-emitting device units 315a, 315b, 315c may be, for example, a micro LED having a size of about 50µm or less as an inorganic light emitting device. In this case, the first to third light-emitting device units 315a, 315b, and 315c may be vertical types in which the common electrode 323 is disposed on the light emitting surface and the individual electrodes 320 are disposed on the opposite surface of the light emitting surface. Here, the common electrode 323 may be a positive electrode, and the individual electrode 320 may be a negative electrode.

According to an embodiment, the common electrode 323 may be integrally formed on a portion of the light emitting surface of the first to third light-emitting device units 315a, 315b, 315c. For example, the common electrode 323 may be an upper portion of the first semiconductor layer 311 of the first to third light-emitting device units 315a, 315b, 315c. Accordingly, the common electrode 323 may electrically and physically connect adjacent first to third light-emitting device units 315a, 315b, 315c.

According to an embodiment, the common electrode 323 may include a semiconductor material forming a part of the first semiconductor layer 311. Thus, the common electrode 323 may have a relatively high electrical resistance compared to a metal. Each of the sub-pixels receives a current through the common electrode 323, and a voltage drop (IR drop) phenomenon may occur due to a resistance difference according to a location of the sub-pixel on the display module 160. This may cause a difference in brightness between the subpixels to degrade display uniformity. According to an embodiment of the disclosure, the common electrode 323 may include a metal layer 340 disposed inside the barrier rib 312 as shown in FIG. 4 and formed in a grating shape with respect to the entire area of the display module 160. The common electrode 323 includes the metal layer 340, thereby increasing electrical conductivity. Therefore, each sub-pixel of the display module 160 may uniformly receive a current of a required magnitude through the common electrode 323 including the metal layer 340, and thus may reduce electric resistance with respect to each sub-pixel and significantly improve display uniformity.

According to an embodiment, the barrier ribs 312 disposed inside the metal layer 340 may be integrally formed with the first semiconductor layer 311 of the light-emitting device units 315a, 315b, 315c. For example, the barrier ribs 312 may be formed of the same material as the first semiconductor layer 311 forming the light-emitting device units 315a, 315b, and 315c without being formed of a material different from that of the light-emitting device units 315a, 315b, and 315c. In this case, in the process of forming the light-emitting device units 315a, 315b, 315c, the barrier ribs 312 may be formed through an etching process on the remaining portion except for a portion used as the first semiconductor layer 311 among the regions used as the first semiconductor layer 311. Accordingly, according to an embodiment of the disclosure, separate processes for forming the barrier ribs 312 may be omitted separately from the process of forming the light-emitting device units 315a, 315b, and 315c. In addition, according to an embodiment of the disclosure, not only the barrier ribs 312 but also the common electrode 323 also uses a portion of the first semiconductor layer 311 of the light-emitting device units 315a, 315b, and 315c, so a separate process for forming the common electrode 323 may be omitted. Therefore, according to the disclosure, when manufacturing a small or subminiature display (for example, a display applied to an augmented reality (AR) wearable device requiring a high resolution in a small size) as high resolution is required, barrier ribs between subpixels are not stacked by a separate process, therefore, work efficiency may be improved, and manufacturing time and manufacturing costs may be reduced by reducing the number of processes.

According to an embodiment, the metal layer 340 functions as the common electrode 323 and reflects light directed to an adjacent sub-pixel. The light emitted from an emission surface of the first light-emitting device unit 315a is not incident to adjacent sub-pixels but is reflected by the metal layer 340, thereby preventing color interference (which may be referred to as crosstalk) between the sub-pixels. Alternatively, the metal layer 340 may be formed of a metal material having a high light absorption rate, and in this case, color interference (hereinafter called, crosstalk) between the subpixels may be prevented by absorbing light emitted from the light emitting surface of the first light-emitting device unit 315a.

According to an embodiment, the individual electrode 320 may be formed of Au or an alloy containing A, but is not limited thereto.

Although not shown in the drawing, according to various embodiments, a light emitting device applied to the substrate 370 may be an organic light emitting diode (OLED) without being limited to an inorganic light emitting device.

According to an embodiment, the first to third light-emitting device units 315a, 315b, 315c may be arranged in a grating arrangement on the substrate 370, but are not limited thereto. However, it is not necessary that the arrangement of first to third light-emitting device units 315a, 315b, 315c is a grating arrangement. For example, a plurality of LEDs may be arranged in a pentile RGBG layout. The pentile RGBG layout is a layout in which the sub-pixels are arranged in such a way that the numbers of red, green, and blue sub-pixels are at a ratio of 1:1:2 (RGBG) based on a cognitive characteristic that a person identifies green better than blue. The pentile RGBG layout may enable an increase in yield and a reduction in unit cost, and enable implementation of a high resolution on a small screen, and thus is effective.

According to an embodiment, the first sub-pixel 201 may include an optical layer 381 having a height corresponding to the first and second color conversion layers 382, 383 instead of the color conversion layer since the first sub-pixel 201 uses the blue light without converting the blue light emitted from the first light-emitting device unit 315a. The optical layer 381 may include a transparent material capable of not affecting or minimizing the transmittance, reflectivity, and refractive index of light emitted from the first light-emitting device unit 315a. Alternatively, the optical layer 381 may adopt a material such as an optical film material capable of minimizing wasted light and improving luminance by directing the light output direction toward an opening of a cell formed by the barrier ribs 312 through refraction and reflection.

According to an embodiment, the first sub-pixel 201 may have a structure in which a first color filter layer 384 is further added to the upper portion of the optical layer 381. The first color filter layer 384 may be an organic material including a dye or a pigment. In this case, the first color filter layer 384 may filter a wavelength different from the wavelength of the light emitted from the first light-emitting device unit 315a.

According to an embodiment, the second sub-pixel 202 may include a first color conversion layer 382 capable of exciting blue light emitted from the second light-emitting device unit 315b to emit red light. For example, the first color conversion layer 382 may be formed of a photosensitive resin including a phosphor or a quantum dot. For example, the phosphor or the quantum dot may absorb incident light of the second light-emitting device unit 315b and isotropically emit light having a wavelength of a band different from that of the incident light. The photosensitive resin may be formed of a material having light transmittance, and may be formed of, for example, a silicone resin, an epoxy resin, an acrylate, a siloxane-based, or a light-transmissive organic material. The plurality of quantum dots included in the first color conversion layer 382 each may function as a point light source and may improve the amount of light further.

According to an embodiment, the second sub-pixel 202 may have a structure in which a second color filter layer 385 is further added to the upper portion of the first color conversion layer 382. The second color filter layer 385 may be an organic material including a dye or a pigment. In this case, the second color filter layer 385 may block leakage light that is not completely converted by the first color conversion layer 382.

According to an embodiment, the third sub-pixel 203 may include the second color conversion layer 383 capable of exciting blue light emitted from the third light-emitting device unit 315c to emit green light. The second color conversion layer 383 may include a photosensitive resin including a phosphor or a quantum dot in the similar manner with the first color conversion layer 382.

According to an embodiment, the third sub-pixel 203 may have a structure in which a third color filter layer 386 is further added to the upper portion of the second color conversion layer 383. The third color filter layer 386 may be an organic material including a dye or a pigment. In this case, the third color filter layer 386 may block leakage light that is not completely converted by the second color conversion layer 382.

According to an embodiment, the first color filter layer 384, the second color filter layer 385, and the third color filter layer 386 may be partitioned by a black matrix 387. As the black matrix 387 is disposed along the upper portion of the barrier ribs 312, the black matrix 387 may have a grating shape.

According to an embodiment, the black matrix 387 absorbs external light to address a problem caused by reflection of external light, thereby improving a contrast ratio and black visibility of a display and improving outdoor visibility. In addition, the black matrix 387 may improve a color reproduction rate of a display by preventing light of different colors emitted from adjacent light emitting elements from being mixed.

According to an embodiment, a plurality of microlenses 390 may be arranged on the uppermost portion of each of the sub-pixels 201, 202, 230. For example, a microlens 390 may be disposed on the first color filter layer 384 in the first sub-pixel 201, a microlens 390 may be disposed on the second color filter layer 385 in the second sub-pixel 202, and a microlens 390 may be disposed on the third color filter layer 386 in the third sub-pixel 203.

According to an embodiment, the plurality of microlenses 390 may be included in, for example, a microlens array formed in the form of a sheet of a thin film. In this case, the pitch between the plurality of microlenses 390 may be set to be substantially the same as the pitch between the plurality of subpixels 201, 202, 203 provided in the display module 160. Accordingly, as described above, the plurality of microlenses 390 may be arranged to correspond to one subpixel, respectively. In this case, the plurality of microlenses 390 all may have the same focal length. However, the embodiments are not limited thereto, and the plurality of microlenses 390 may have different focal lengths for each region, such as a central region and an edge region of the microlens array.

According to an embodiment, the microlens array may be manufactured in the form of a sheet as described above, and then attached on the first color filter layer 384, the second color filter layer 385, and the third color filter layer 386 in a laminating form. In this case, the microlens array may cover a portion of the black matrix 387.

The microlens array can be manufactured by various methods without being limited to the various embodiments. For example, the microlens array may be formed in various ways, such as a high temperature reflow method, a grayscale mask photolithography method, a molding/imprinting method, or a dry etching pattern transfer method.

The high temperature reflow method may refer, for example, to a method in which an optical layer including a photosensitive polymer is stacked on the first color filter layer 384, the second color filter layer 385, the third color filter layer 386, and the black matrix 387, and cells corresponding to each microlens are formed on the optical layer, and when the optical layer is heated for a predetermined time, the optical layer melts into a liquid state, so that a plurality of microlens having a predetermined curvature are formed by surface tension. In this case, the planarization layer may include an optical material or may be an optical adhesive. The planarization layer is a material that is cured in response to light (for example, ultraviolet) of a designated band, and may include, for example, an optical clear adhesive (OCA), an optical clear resin (OCR), or a super view resin (SVR). Alternatively, the planarization layer may include a material capable of maintaining high transparency even in the environment of high temperature or high humidity.

The grayscale mask photolithography method may refer, for example, to a method in which an optical layer comprising a photosensitive polymer is laminated on the first color filter layer 384, the second color filter layer 385, the third color filter layer 386, and the black matrix 387, and an optical layer is exposed and developed to form an upper surface of the optical layer into a plurality of microlenses.

In the molding/imprinting method, an optical layer comprising a photosensitive polymer is laminated on the first color filter layer 384, the second color filter layer 385, the third color filter layer 386, and the black matrix 387, and an optical layer is pressed by a stamp under a predetermined temperature so that the upper surface is formed of a plurality of microlenses. In this case, the stamp may have a dome-shaped groove corresponding to a plurality of microlenses to be formed in the optical layer.

The dry pattern transfer method may refer, for example, to a method of stacking an optical layer comprising a photosensitive polymer on the first color filter layer 384, the second color filter layer 385, the third color filter layer 386, and the black matrix 387, and molding the optical layer into a plurality of microlenses through plasma etching.

Before molding a plurality of microlenses 390 by the various methods described above, a process of aligning locations of light-emitting device units 315a, 315b, 315c corresponding to each microlens 390 with a location in which a plurality of microlenses 390 are to be molded may be preceded.

Hereinafter, an example method of manufacturing a display module according to an embodiment of the disclosure will be described with reference to drawings.

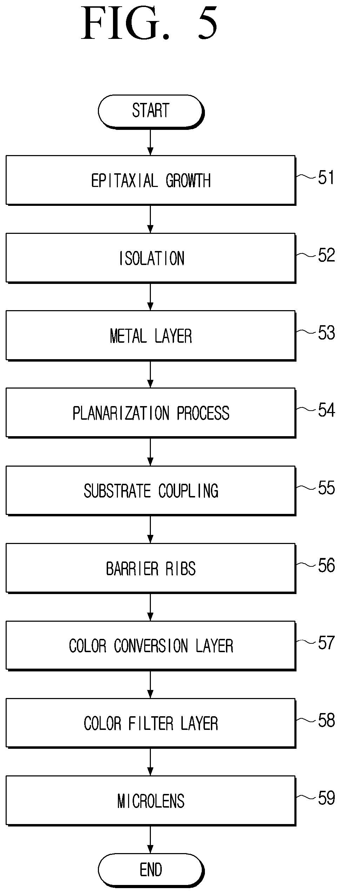

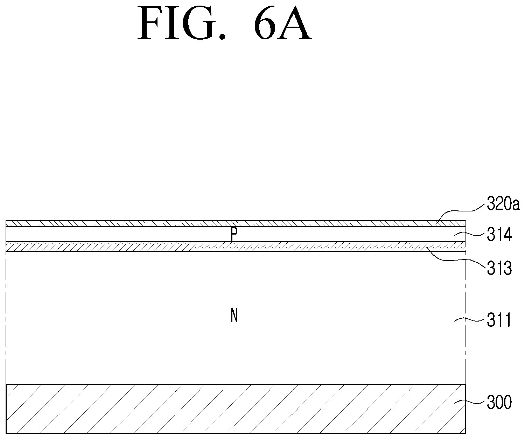

FIG. 5 is a flowchart schematically illustrating a method of manufacturing a display module according to an embodiment of the disclosure, FIGS. 6A to 6L are diagrams illustrating processes of manufacturing a display module according to an embodiment of the disclosure.

Referring to FIG. 6A, a first semiconductor layer 311, an active layer 313, and a second semiconductor layer 314 may be sequentially epi-grown on the growth substrate 300 (51). In this case, a material of the growth substrate 300 may be silicon or a Sapphire.

According to an embodiment, the first semiconductor layer 311, the active layer 313, and the second semiconductor layer 314 may be sequentially generated on the growth substrate 300 using a method such as metal organic chemical vapor deposition (MOCVD), chemical vapor deposition (CVD), or plasma-enhanced chemical vapor deposition (PECVD).

According to an embodiment, the first semiconductor layer 311 may include, for example, an n-type semiconductor layer (cathode, reduced electrode). The n-type semiconductor layer may be selected from, for example, GaN, AlN, AlGaN, InGaN, InN, InAlGaN, AlInN, or the like, and may be doped with a n-type dopant such as Si, Ge, or Sn. According to an embodiment, the second semiconductor layer 314 may include, for example, a p-type semiconductor layer (anode, oxide electrode). The p-type semiconductor layer may be selected from, for example, GaN, AlN, AlGaN, InGaN, InN, InAlGaN, AlInN, or the like, and may be doped with a p-type dopant such as Mg, Zn, Ca, Sr, or Ba. According to an embodiment, the active layer 313 is a region in which electrons and holes are recombined. The active layer 313 may transition to a low energy level by recombination of electrons and holes, and may generate light having a corresponding wavelength. The active layer 313 may include a semiconductor material such as amorphous silicon or poly crystalline silicon. The embodiments are not limited thereto and may include an organic semiconductor material, and may be formed in a single quantum well (SQW) structure or a multi quantum well (MQW) structure.

According to an embodiment, the first semiconductor layer 311, the active layer 313, and the second semiconductor layer 314 may form the light-emitting device unit.

According to an embodiment, after epitaxial growth, an electrode layer 320a to be used as an individual electrode of each light-emitting device unit may be deposited with a predetermined thickness on the second semiconductor layer 314 through a process such as sputtering.

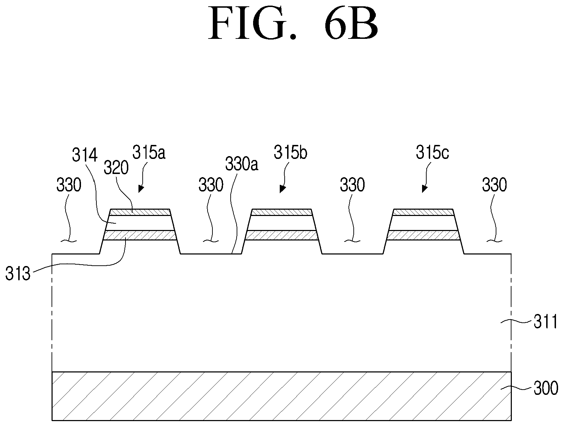

Referring to FIG. 6B, a photolithography process and an etching process are repeatedly performed and perform isolation for the first semiconductor layer 311, the active layer 313, the second semiconductor layer 314, and the electrode layer 320a in the units of light-emitting device units 315a, 315b, and 315c, respectively (52). In this case, predetermined spaces 330 may be formed between each of the light-emitting device units 315a, 315b, 315c.

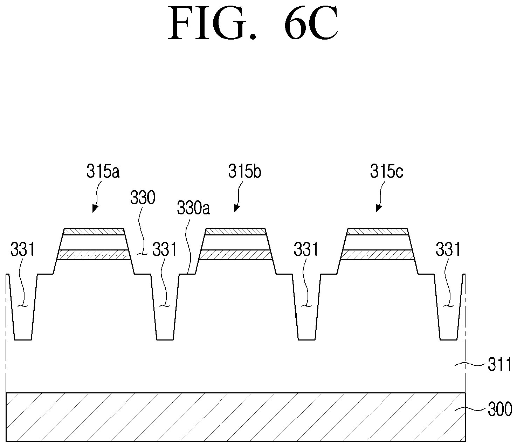

Referring to FIG. 6C, a plurality of trenches 331 having a predetermined depth may be formed in the first semiconductor layer 311 exposed by each of the spaces 330. The depth of the plurality of trenches 331 may determine the height of the metal layer 340 by a subsequent process. For example, as shown in FIG. 6C, when the trench 331 is formed to approximately the intermediate height of the first semiconductor layer 311, the height of the trench 331 may be lower than the height of the barrier ribs 312 formed in the subsequent process. Alternatively, when the trench 331 is formed up to the lower end of the first semiconductor layer 311, the height of the trench 331 may be substantially the same as the height of the barrier ribs 312.

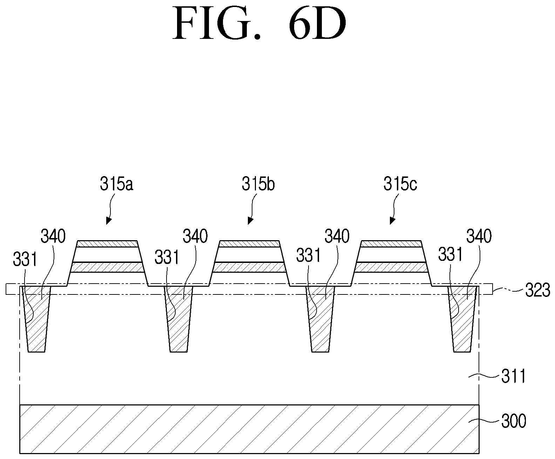

Referring to FIG. 6D, a plurality of metal layers 340 may be formed by filling a plurality of trenches 331 with a metal material (53). The metal layer 340 may partition each light-emitting device unit 315a, 315b, and 315c together with the barrier ribs while playing a role as the common electrode 323. For example, the metal layer 340 may be formed of a metal material having high conductivity and high reflectivity. The metal layer 340 may be formed of a metal material having high conductivity and high light absorption rate. The metal layer 340 may prevent crosstalk between the subpixels by reflecting or absorbing light.

According to an embodiment, as shown in FIG. 6D, a portion of the first semiconductor layer 311 may be used as the common electrode 323. The common electrode 323 may include the metal layer 340 and may increase conductivity. Accordingly, the common electrode 323 may stably apply a current of a required magnitude to each of the sub-pixels, thereby preventing a voltage drop that may occur due to a resistance difference according to the location of the sub-pixel and thus may improve display uniformity.

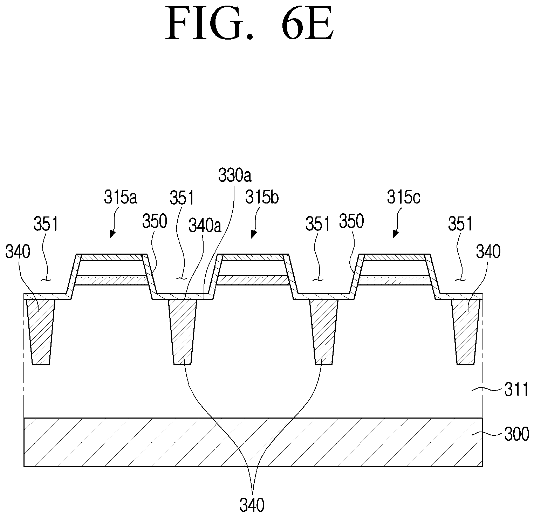

Referring to FIG. 6E, the passivation layer 350 may be formed to protect each light-emitting device unit 315a, 315b, 315c from an external environment such as moisture and oxygen. The passivation layer 350 may cover the side surfaces of the light-emitting device units 315a, 315b, and 315c, the bottom portion 330a of the space, and a portion 340a of the metal layer 340 located on substantially the same plane as the bottom portion 330a.

In an embodiment, the passivation layer 350 may include an inorganic insulating film (e.g., silicon oxide (SiO₂)) and/or an organic insulating film (e.g., a general-purpose polymer (PMMA, PS)). For example, the passivation layer 350 may be formed in a composite laminated structure of an inorganic insulating film and an organic insulating film.

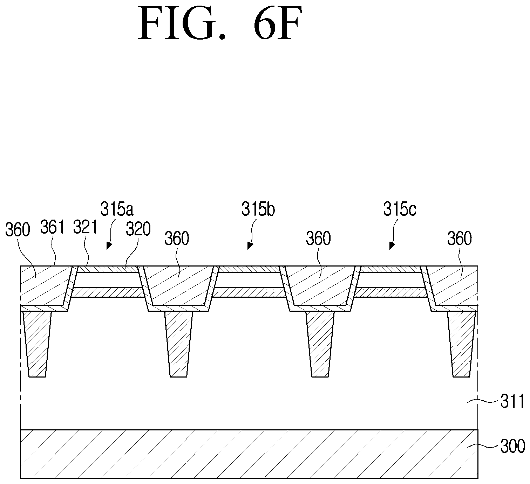

Referring to FIG. 6F, each of the spaces 351 (see FIG. 6E) located among the light-emitting device units 315a, 315b, and 315c may be filled with a material such as SiO₂ and may perform a planarization process (54). In this case, the surface 361 of the planarization layer 360 may be located on substantially the same plane as the surface 321 of the individual electrode 320.

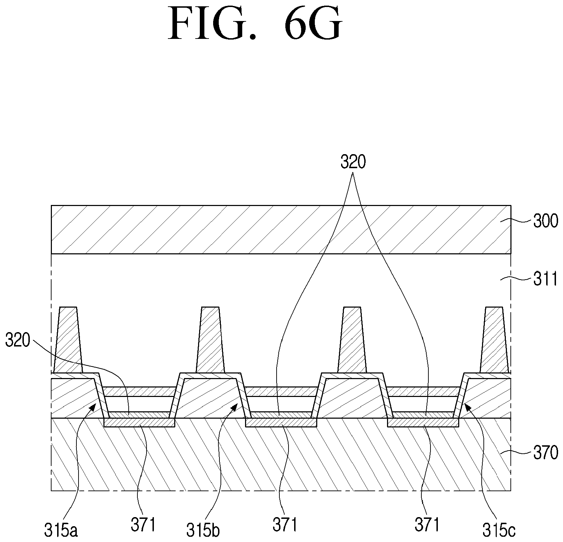

Referring to FIG. 6G, the growth substrate 300 may be turned upside down so that the planarized part faces the substrate 370 provided with the TFT circuit to be coupled to the substrate 370 through a thermocompression process (55). In this case, the individual electrodes 320 may be electrically connected to corresponding substrate electrode pads 371, respectively. In addition, the individual electrodes 320 may be physically connected by being fused with the substrate electrode pads 371 during the thermocompression process.

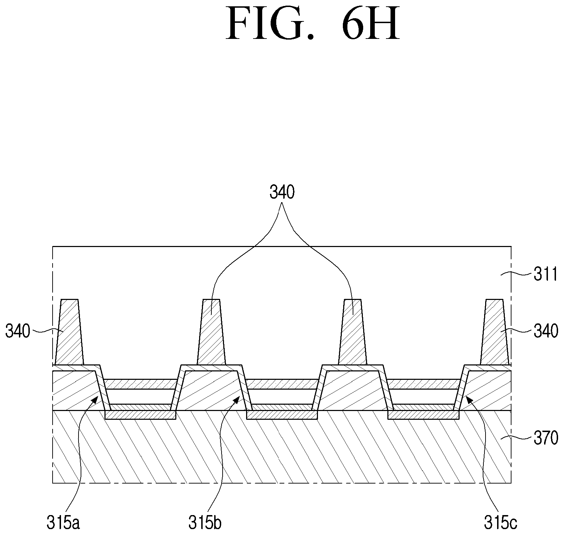

Referring to FIG. 6H, the growth substrate 300 may be removed from the first semiconductor layer 311 through a laser lift-off (LLO) process.

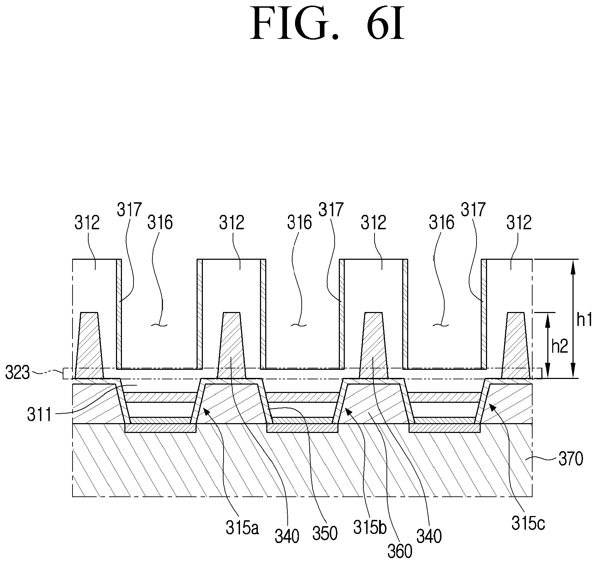

Referring to FIG. 6I, the barrier ribs 312 may be formed on one surface of the first semiconductor layer 311 from which the growth substrate 300 is removed through a photolithography process and an etching process (56). In this case, the barrier ribs 312 may be formed at a portion of the first semiconductor layer 311 without being formed of a separate material, so that the barrier ribs 312 may be integrally formed with the first semiconductor layer 311.

According to an embodiment, the barrier ribs 312 may be disposed at a location approximately corresponding to the planarization layer 360, and each trench 316 may be located above the corresponding light-emitting device units 315a, 315b, and 315c. Each trench may be filled with an optical material or a color conversion material.

According to an embodiment, the metal layer 340 is located inside the barrier ribs 312. As shown in FIG. 4, the barrier ribs 312 may be formed in an approximately grating shape, and the metal layer 340 located inside the barrier ribs 312 may also be formed in an approximate grating shape.

According to an embodiment, the height (h1) of the barrier ribs 312 may be greater than the height (h2) of the metal layer 340. However, the embodiments are not limited thereto and the height h2 of the metal layer 340 may be formed to be lower than the height illustrated in FIG. 6I or may be formed to be higher. According to an embodiment, the metal layer 340 may have a width smaller than the width of the barrier ribs 312 to be disposed inside the barrier ribs 312.

According to an embodiment, a reflective film 317 may be deposited on the side surface of the barrier ribs 312. For example, the reflective film 317 may be formed of a metal material (e.g., aluminum) having high reflectivity. The reflective layer 317 may block light emitted from the light-emitting device units 315a, 315b, and 315c from being incident on an adjacent sub-pixel. In this case, a lower end of the reflective film 317 is located above the common electrode 323, so that light emitted from the light-emitting device units 315a, 315b, and 315c may be incident to an adjacent subpixel side through the common electrode 323. However, in the disclosure, since the lower end of the metal layer 340 is disposed at a location lower than the lower end of the reflective layer 317 (for example, a location in close contact with the passivation layer 350 on the planarization layer 360), light emitted from the light-emitting device units 315a, 315b, and 315c may not be incident to the adjacent sub-pixel through the common electrode 323. Accordingly, crosstalk between adjacent sub-pixels may be prevented.

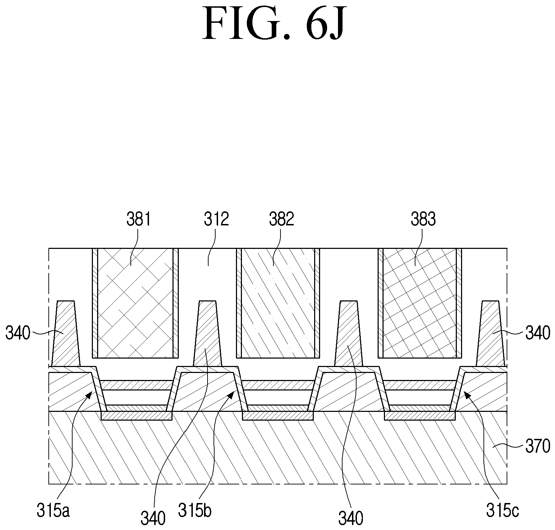

Referring to FIG. 6J, the trench 316 corresponding to the first light-emitting device unit 315a fills an optical material to form an optical layer 381, and trenches 316 corresponding to the second and third light-emitting device units 315b and 315c may be filled with a color conversion material to form first and second color conversion layers 382 and 383 (57).

According to an embodiment, the color conversion material forming the first color conversion layer 382 and the color conversion material forming the second color conversion layer 383 excite incident light to emit light of different colors. The color conversion materials may include a phosphor or a quantum dot in the photosensitive resin.

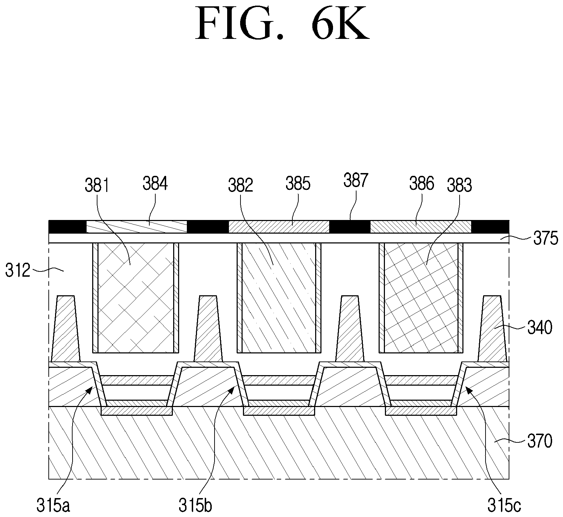

Referring to FIG. 6K, a thin film encapsulation layer 375 covering the first and second color conversion layers 382 and 383 may be formed to protect the first and second color conversion layers 382 and 383. In this case, the thin film encapsulation layer 375 may cover not only the first and second color conversion layers 382 and 383 but also the upper surface of the barrier ribs 312 and the optical layer 381.

According to an embodiment, a first color filter layer 384, a second color filter layer 385, a third color filter layer 386, and a black matrix 387 may be formed on the thin film encapsulation layer 375 (58). In this case, the first to third color filter layers 384, 385, 386 may filter different colors. For example, after sequentially forming the first color filter layer 384, the second color filter layer 385, and the third color filter layer 386 on the thin film encapsulation layer 375, a black matrix 387 may be formed. However, the first color filter layer 384, the second color filter layer 385, the third color filter layer 386, and the black matrix 387 may not necessarily be formed according to this sequence.

According to an embodiment, the first color filter layer 384 may be formed at a location corresponding to the optical layer 381, and may be formed to have a width wider than the width of the optical layer 381 to completely cover the optical layer 381. The second color filter layer 385 may be formed at a location corresponding to the first color conversion layer 382, and may be formed to have a width wider than a width of the first color conversion layer 382 to completely cover the first color conversion layer 382. The third color filter layer 386 may be formed at a location corresponding to the second color conversion layer 383, and may be formed to have a width wider than a width of the second color conversion layer 383 to completely cover the second color conversion layer 383.

The black matrix 387 may be formed along an upper portion of the barrier ribs 312, and may isolate the first color filter layer 384, the second color filter layer 385, and the third color filter layer 386.

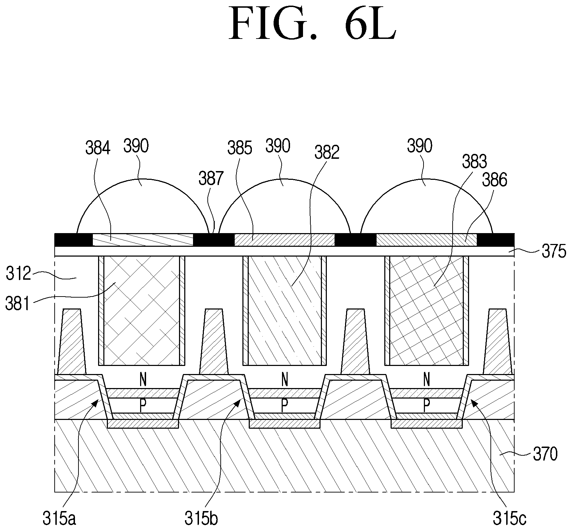

Referring to FIG. 6L, the microlenses 390 may be formed on the first color filter layer 384, the second color filter layer 385, and the third color filter layer 386, respectively (59). For example, a plurality of microlenses 390 may attach a sheet having a plurality of microlens arrays to an upper surface of a first color filter layer 384, a second color filter layer 385, and a third color filter layer 386. However, the embodiments are not limited thereto, and the plurality of microlenses 390 may be manufactured by various methods. For example, the microlens array may be formed in various ways, such as a high temperature reflow method, a grayscale mask photolithography method, a molding/imprinting method, or a dry etching pattern transfer method.

In an embodiment of the disclosure, a display module having pixels 200 formed through various processes may be formed as described above. In this case, each of the subpixels 201, 202, and 203 forming the pixel 200 may use a portion of the light-emitting device units 315a, 315b, and 315c as the common electrode 323. In this case, the common electrode 323 including the metal layer 340 disposed in the barrier ribs 312 may stably apply a current required for each sub-pixel of the display module by securing high electrical conductivity. Accordingly, a voltage drop due to a resistance difference according to the location of the sub-pixel may be minimized, thereby improving display uniformity.

Hereinafter, a pixel structure according to various embodiments of the disclosure will be described, wherein a reference numeral identical to a member number assigned to each component of the pixel 200 may be assigned to substantially the same configuration as the pixel 200 described above, and a description thereof may not be repeated.

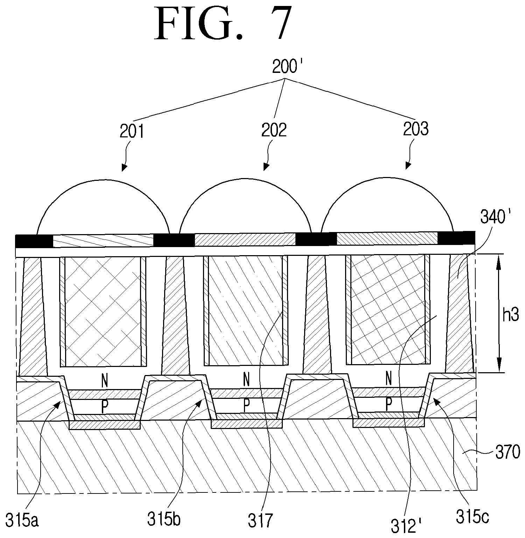

FIG. 7 is a cross-sectional view illustrating a pixel structure of a display module according to another embodiment of the disclosure.

The pixel 200' of the display module according to an embodiment of the disclosure is mostly similar with the pixel 200 described above and may have a difference in the height (h3) of the metal layer 340'.

According to an embodiment, the upper end of the metal layer 340' may have the same height as the height of the barrier rib 312'. Each of the subpixels 201, 202, and 203 may substantially completely block light emitted from the neighboring light emitting elements from being incident on adjacent subpixels by the metal layer 340'. In this case, since the metal layer 340' may replace the reflective layer 317 formed on the side surface of the barrier rib 312', the reflective layer 317 may be omitted.

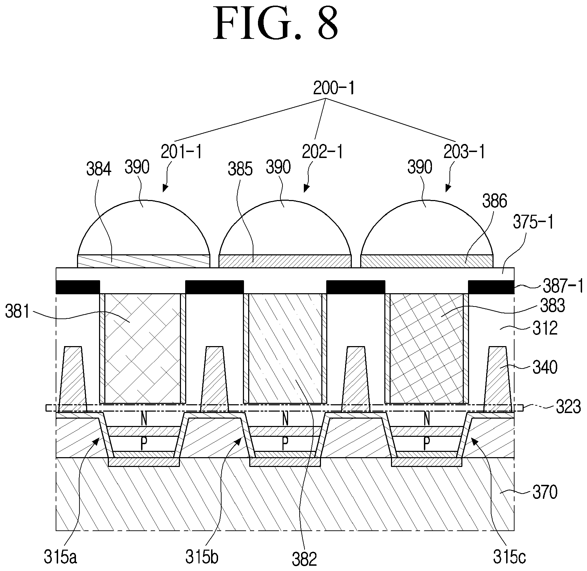

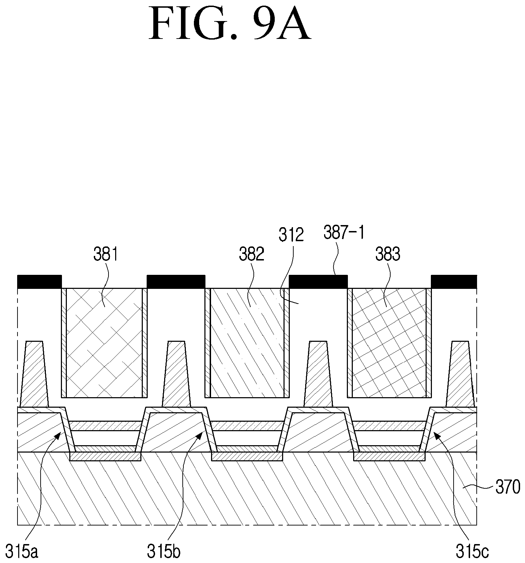

FIG. 8 is a cross-sectional view illustrating a pixel structure of a display module according to another embodiment of the disclosure, FIGS. 9A to 9D are diagrams illustrating processes of manufacturing a display module according to another embodiment of the disclosure.

Referring to FIG. 8, in the case of the pixel 200-1 of a display module according to an embodiment of the disclosure, the structure of each of the sub-pixels 201-1, 202-1, 203-1 is substantially the same as the structure of each of the sub-pixels 201, 202, 203 of the aforementioned pixel 200, and some of the structure is different.

For example, each of the subpixels 201-1, 202-1, and 203-1 is different from each of the subpixels 201, 202, and 203 in that the first color filter layer 384, the second color filter layer 385, and the third color filter layer 386 are disposed at a different height from the black matrix 387.

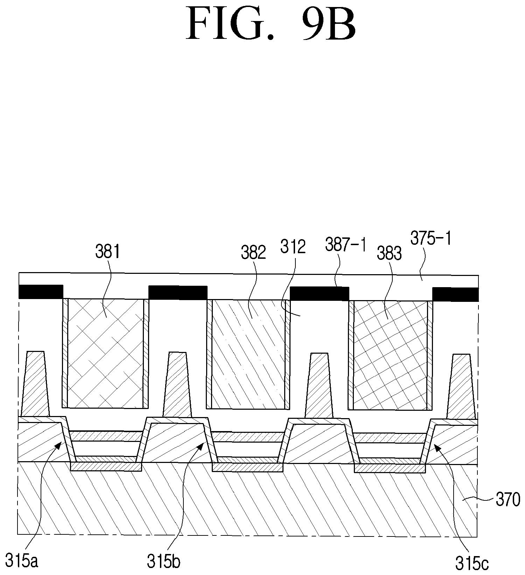

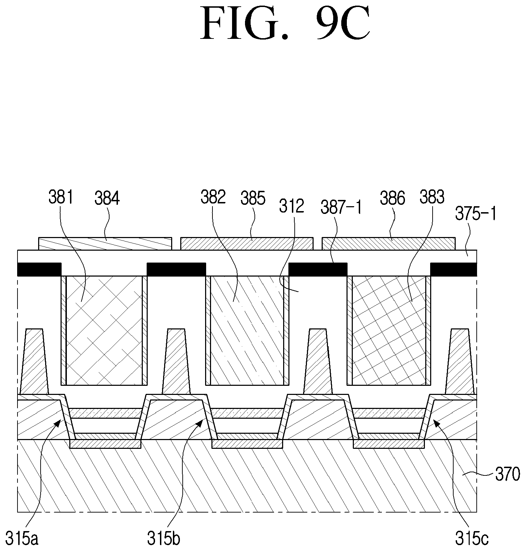

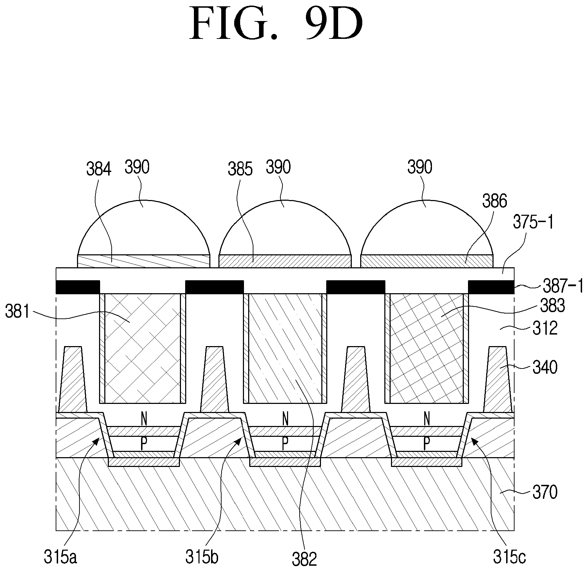

According to an embodiment, the pixel 200-1 may have a substantially the same process (see FIG. 6J) of forming the optical layer 381, the first color conversion layer 382, and the second color conversion layer 383 as the manufacturing process of the pixel 200 described above. Hereinafter, a manufacturing process of the pixel 200-1 will be described in greater detail with reference to FIGS. 9A, 9B, 9C and 9D following the process (see FIG. 6J).

Referring to FIG. 9A, the black matrix 387-1 may be formed on the upper portion of the barrier ribs 312. The width of the black matrix 387-1 may be formed to correspond to the width of the barrier ribs 312 to substantially cover the upper portion of the barrier ribs.

Referring to FIG. 9B, a thin film encapsulation layer 375-1 covering the first and second color conversion layers 382 and 383 may be formed to protect the first and second color conversion layers 382 and 383. In this case, the thin film encapsulation layer 375-1 may cover not only the first and second color conversion layers 382 and 383 but also the optical layer 381 and the black matrix 387-1.

According to an embodiment, the thin film encapsulation layer 375-1 may fill a step between the upper surface of the optical layer 381 and the first and second color conversion layers 382, 383 and the black matrix 387-1. In this case, the upper surface of the thin film encapsulation layer 375-1 may be planarized through a polishing process.

Referring to FIG. 9C, the first to third color filter layers 384, 385, and 386 may be sequentially formed on the thin film encapsulation layer 375-1. For example, the first color filter layer 384 may be disposed at a location corresponding to the optical layer 381, and may have a width wider than a width of the optical layer 381. The second color filter layer 385 may be disposed at a location corresponding to the first color conversion layer 382, and may have a width wider than a width of the first color conversion layer 382. The third color filter layer 386 may be disposed at a location corresponding to the second color conversion layer 383, and may have a width wider than a width of the second color conversion layer 383.

Referring to FIG. 9D, microlenses 390 may be formed on the first color filter layer 384, the second color filter layer 385, and the third color filter layer 386, respectively. For example, a plurality of microlenses 390 may attach a sheet having a plurality of microlens arrays to an upper surface of the first color filter layer 384, the second color filter layer 385, and the third color filter layer 386. However, the embodiments are not limited thereto, and the plurality of microlenses 390 may be manufactured by various methods. For example, the microlens array may be formed in various ways, such as a high temperature reflow method, a grayscale mask photolithography method, a molding/imprinting method, and a dry etching pattern transfer method.

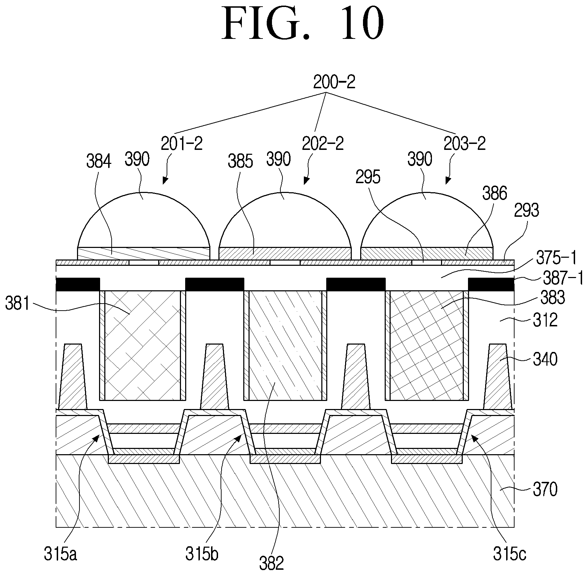

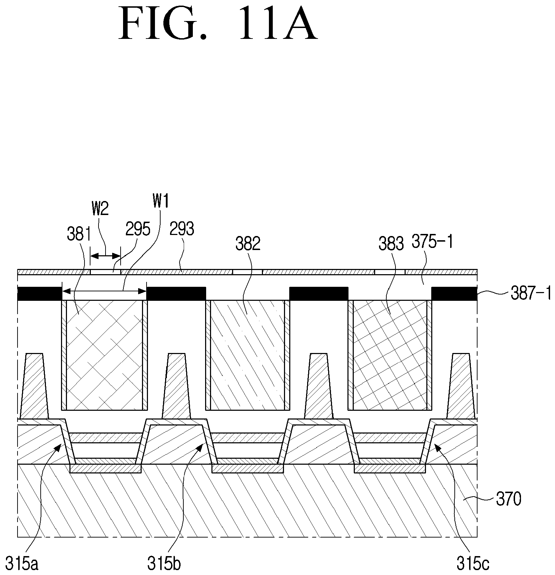

FIG. 10 is a cross-sectional view illustrating a pixel structure of a display module according to another embodiment of the disclosure, FIGS. 11A to 11D are diagrams illustrating processes of manufacturing a display module according to another embodiment of the disclosure.

Referring to FIG. 10, in the case of the pixel 200-2 of a display module according to an embodiment of the disclosure, the structure of each sub-pixels 201-2, 202-2, 203-2 has substantially the same structure as each of the sub-pixels 201-1, 202-1, 203-1 of the pixel 200-1 described above, and is different in that the reflective layer 293 is further included below the microlens 390.

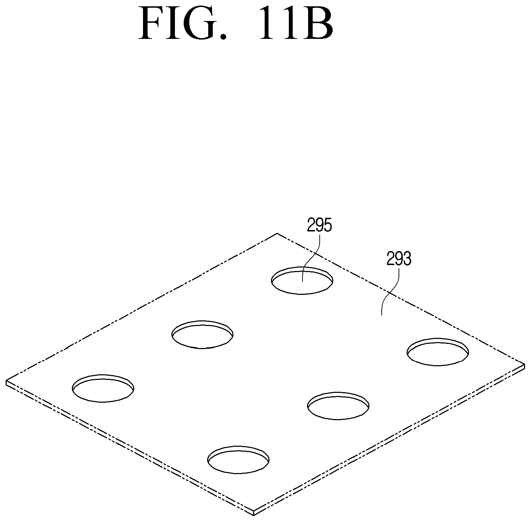

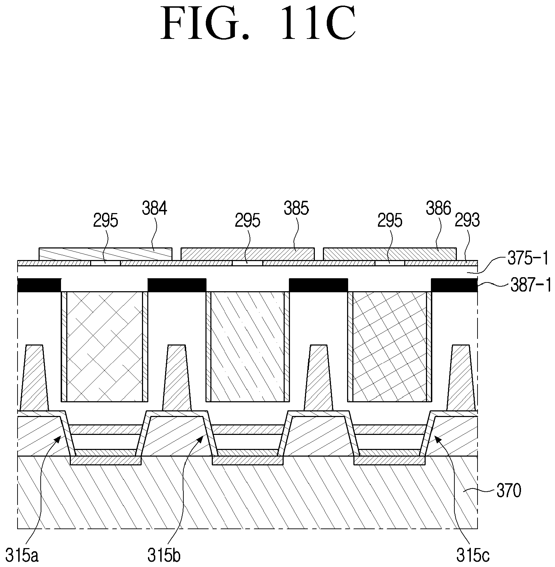

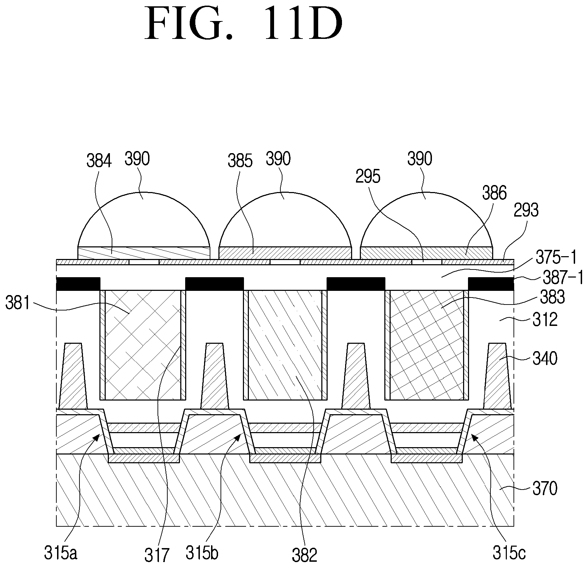

According to an embodiment, the pixel 200-2 may be substantially the same as the manufacturing process of the pixel 200 described above until a process of forming a thin film encapsulation layer 375-1 covering the optical layer 381, the first color conversion layer 382, the second color conversion layer 383, and the black matrix 387-1 (see FIG. 9B). Hereinafter, a manufacturing process of the pixel 200-2 will be described with reference to FIGS. 11A, 11B, 11C and 11D following the process (see FIG. 9B).

Referring to FIGS. 11A and 11B, a reflective layer 293 may be formed on an upper surface of a thin film encapsulation layer 375-1. For example, the reflective layer 293 may include a plurality of openings 295 through which light passes. In this case, each opening 295 may be disposed at a location corresponding to each light-emitting device unit 315a, 315b, and 315c, and may have a width w2 smaller than a width w1 between the barrier ribs 312.

According to an embodiment, the opening 295 may be disposed at a location corresponding to approximately the central portion of the light-emitting device unit. However, the embodiments are not limited thereto, and may be disposed at a location without departing from the region of the light-emitting device unit. For example, an opening corresponding to a light-emitting device unit adjacent to the left side of the display module 160 may be arranged to be deflected to the right from the center of the light-emitting device unit. Alternatively, an opening corresponding to a light-emitting device unit adjacent to the right side of the display module 160 may be arranged to be deflected to the left from the center of the light-emitting device unit. The arrangement of the opening 295 may consider a condition in which the amount of light emitted from the front surface of the display module 160 beyond the edge of the display module 160 is wasted is minimized and the amount of light emitted forward is maximized.

According to an embodiment, the reflective layer 293 may be formed of a material having a high light reflectivity. For example, the reflective layer 293 may be a metal layer, a resin layer containing a metal oxide, or a distributed bragg reflective layer. A thickness of the reflective layer 293 may be approximately 100 nm to 500 nm. The metal layer may be Al, Au, Ag, Pt, Ni, Cr, Ti, or Cu. The resin layer including the metal oxide may be a resin layer including titanium oxide. A plurality of insulating layers having different refractive indexes may be repeatedly stacked several to hundreds of times, for example, twice to 100 times of the distributed bragg reflective layer. The insulating layer of the distributed bragg reflective layer may be an oxide or a nitride of SiO₂, SiN, SiOxNy, TiO₂, Si₃N₄, Al₂O₃, TiN, AlN, ZrO₂, TiAlN, TiSiN, or a group thereof.

Referring to FIG. 11C, first to third color filter layers 384, 385, and 386 may be sequentially formed on the reflective layer 293. For example, the first color filter layer 384 may be disposed at a location corresponding to the optical layer 381, and may have a width wider than a width of the optical layer 381. The second color filter layer 385 may be disposed at a location corresponding to the first color conversion layer 382, and may have a width wider than a width of the first color conversion layer 382. The third color filter layer 386 may be disposed at a location corresponding to the second color conversion layer 383, and may have a width wider than a width of the second color conversion layer 383.

Referring to FIG. 11D, microlenses 390 may be formed on the upper surfaces of the first color filter layer 384, the second color filter layer 385, and the third color filter layer 386, respectively. For example, a plurality of microlenses 390 may attach a sheet having a plurality of microlens arrays to an upper surface of the first color filter layer 384, the second color filter layer 385, and the third color filter layer 386. However, the embodiments are not limited thereto, and the plurality of microlenses 390 may be manufactured in various manners. For example, the microlens array may be formed in various manners such as a high temperature reflow method, a grayscale mask photolithography method, a molding/imprinting method, or a dry etching pattern transfer method.

The amount of light of the pixel 200-2 formed through this process emitted in a front direction may be maximized. For example, light emitted from the first light-emitting device unit 315a may pass through the optical layer 381 and may be partially incident on the first color filter layer 384 through the opening 295, and the rest may be reflected on the inner surface of the reflective layer 293 to be directed toward the first light-emitting device unit 315a or may be re-reflected by the reflective layer 293. In this case, the remaining light may be reflected in the sub-pixel several times, and may then be incident on the first color filter layer 384 through the opening 295. Accordingly, light that has passed through the first color filter layer 384 may be concentrated to the microlens 390 and then emitted to a front surface (for example, a direction toward the incident surface of the projection lens 110). In this case, as to the limit emitted through the opening 295, the amount of light emitted in the front direction may be maximum and thus, wasted light may be minimized and luminance may be improved. Light emitted from each of the second light-emitting device unit 315b and the third light-emitting device unit 315c may be concentrated when passing through the opening 295 of the reflective layer 293, concentrated to the microlens 390, and then emitted in a front surface (for example, a direction toward the incident surface of the projection lens 110).

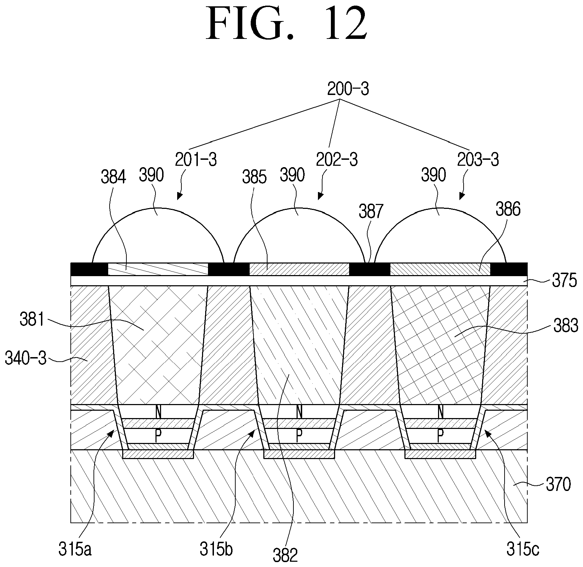

FIG. 12 is a cross-sectional view illustrating a pixel structure of a display module according to another embodiment of the disclosure.

Referring to FIG. 12, in the pixel 200-3 of a display module according to an embodiment, the structure of each of the sub-pixels 201-3, 202-3, 203-3 is substantially the same as the structure of each sub-pixels 201, 202, 203 of the pixel 200 described above, and is only partially different.

According to an embodiment, in the pixel 200-3, barrier ribs (see reference numeral 312 of FIG. 3) partitioning each of the sub-pixels 201-3, 202-3, 203-3 are omitted, and the metal layer 340-3 may independently partition each of the sub-pixels 201-3, 202-3, 203-3 instead of the barrier ribs.

According to an embodiment, an upper end of the metal layer 340-3 may have a height in contact with the thin film encapsulation layer 375. In this case, a reflective film (see reference numeral 317 of FIG. 3) disposed on a side surface of the barrier rib may be omitted

The display module 160 according to various embodiments o the disclosure may include the substrate 370, a plurality of light-emitting device units 315a, 315b, 315c arranged on the substrate 370, barrier ribs 312 extending from the plurality of light-emitting device units 315a, 315b, 315c and partitioning sub-pixel regions, a color conversion layer 382, 383 disposed on an upper portion of the plurality of light-emitting device units 315a, 315b, 315c and configured to emit excitation light using light emitted from the plurality of light-emitting device units 315a, 315b, 315c, a common electrode 323 including a metal layer 340 that is disposed, as a portion of the plurality of light-emitting device units 315a, 315b, 315c, on upper portions of the plurality of light-emitting device units 315a, 315b, 315c connecting the respective light-emitting device units 315a, 315b, 315c and inside the barrier ribs 312 to be in contact with the upper portions of the plurality of light-emitting device units 315a, 315b, 315c, and a plurality of individual electrodes 320 that are respectively disposed on opposite surfaces of light-emitting surfaces of the plurality of light-emitting device units 315a, 315b, 315c.

According to various example embodiments, the metal layer 340 may include a grating type according to a shape of the barrier ribs 312.

According to various example embodiments, each of the plurality of light-emitting device units 315a, 315b, 315c may include a first semiconductor layer 311 having one side integrally formed with the common electrode 323, a second semiconductor layer 314 connected to the individual electrode 320, and an active layer 313 disposed between the first semiconductor layer 311 and the second semiconductor layer 314.

According to various example embodiments, the barrier ribs 312 may extend from the common electrode 323. The barrier ribs may be integrally formed and comprise substantially the same material.

According to various example embodiments, the height h2 of the metal layer 340 may be less than or equal to the height of the barrier ribs 312. The height h3 of the metal layer 340' may be substantially the same as the height of the barrier ribs 312'.

According to various example embodiments, a lower end of the metal layer 340 may be disposed at a location lower than a lower end of the color conversion layer 382, 383. The lower end of the metal layer 340 may be disposed between the plurality of light-emitting device units 315a, 315b, 315c and located at an upper portion of a planarization layer 360 isolating the plurality of light-emitting device units 315a, 315b, 315c.

According to various example embodiments, a reflective film 317 may be formed inside the barrier ribs 312. Light emitted from each of the light-emitting device units 315a, 315b, and 315c is configured to be reflected in the trenches 316 provided between the barrier ribs 312 and is prevented from being emitted toward an adjacent sub-pixel. For example, based on the metal layer 340 being formed of a metal material having a high light reflectance, the metal layer 340 may prevent light from being emitted toward an adjacent sub-pixel.

According to various example embodiments, an optical layer 381 may be disposed at an upper portion of some of the plurality of light-emitting device units 315a, 315b, 315c.

According to various example embodiments, the plurality of light-emitting device units 315a, 315b, 315c may be configured to emit light of a substantially the same wavelength (e.g., blue light).

According to various example embodiments, the display module 160 may further include a plurality of color filter layers 384, 385, 386 disposed at an upper portion of the color conversion layer 382, 383 and an upper portion of the optical layer 381.

According to various example embodiments, the display module 169 may further include a black matrix 387, 387-1 partitioning the plurality of color filter layers 384, 385, 386. The black matrix 387, 387-1 may be located above the barrier ribs 312.

According to various example embodiments, the display module 160 may further include a plurality of microlenses 390 disposed on an upper surface of the plurality of color filter layers 384, 385, 386.

According to various example embodiments, the display module 160 may further include a black matrix 387-1 disposed above the barrier ribs 312, a thin film encapsulation layer 375-1 covering the color conversion layer 382, 383, the optical layer 381, and the black matrix 387-1, a plurality of color filters 384, 385, 386 disposed on an upper surface of the thin film encapsulation layer 375-1 and corresponding to the optical layer 381, a plurality of microlenses 390 disposed on an upper surface of the plurality of color filter layers 384, 385, 386.

According to various example embodiments, the display module 160 may further include a reflective layer 923 disposed at a lower portion of the plurality of microlenses 390 and configured to collect light emitted from the plurality of light-emitting device units 315a, 315b, 315c to a corresponding microlens 390. The reflective layer 293 may include a plurality of openings 295 reducing an area of light emission before the light emitting from the light-emitting device units 315a, 315b, 315c is incident on the corresponding microlens 390. The opening 295 may have the width w2 smaller than the width w1 of the space between the barrier ribs 312.

According to various example embodiments, the reflective layer 293 may be disposed between the thin film encapsulation layer 375-1 and a plurality of color filters 384, 385, 386.

According to various example embodiments, a wearable electronic device 101 may include a display module 160 including the substrate 370 and a plurality of sub-pixels 201, 202, 203 arranged on the substrate 370; a projection lens 110 configured to concentrate light emitted from the display module 160; and a diffraction optical member 111 comprising an optical waveguide configured to introduce light emitted from the projection lens at one side and to emit the light to another side. The plurality of subpixels 201, 202, 203; 201-1, 202-1, 203-1; 201-2, 202-2, 203-2; 201-3, 202-3, 203-3 may include a plurality of light-emitting device units 315a, 315b, 315ccomprising at least one layer, barrier ribs 312 extending from the plurality of light-emitting device units 315a, 315b, 315c and partitioning sub-pixel regions, an optical layer 381 and a color conversion layer 382, 383 disposed between the barrier ribs 312, a plurality of color filter layers 384, 385, 386 disposed on an upper portion of the color conversion layer 382, 383 and an upper portion of the optical layer 381, a black matrix 387, 387-1 partitioning the plurality of color filter layers 384, 385, 386, a plurality of microlenses 390 disposed on an upper surface of the plurality of color filter layers 384, 385, 386, a common electrode 323 including a metal layer 340 that is disposed, as a portion of the plurality of light-emitting device units 315a, 315b, 315c, on upper portions of the plurality of light-emitting device units 315a, 315b, 315c connecting the respective light-emitting device units 315a, 315b, 315c and inside the barrier ribs 312 to be in contact with the upper portions of the plurality of light-emitting device units 315a, 315b, 315c, and a plurality of individual electrodes 320 that are respectively disposed on opposite surfaces of light-emitting surfaces of the plurality of light-emitting device units 315a, 315b, 315c.

According to various example embodiments, the metal layer 340 include a grating shape along a shape of the barrier ribs 312, and the barrier ribs 312 may extend from the common electrode 323.

The various embodiments of the disclosure have been described individually, but each embodiment does not necessarily have to be implemented alone, and the configuration and operation of each embodiment may be implemented in combination with at least one other embodiment.

The foregoing embodiments and advantages are merely examples and are not to be construed as limiting the disclosure. The present teaching may be readily applied to other types of apparatuses. Also, the description of the embodiments of the disclosure is intended to be illustrative, and not to limit the scope of the claims, and many alternatives, modifications, and variations will be apparent to those skilled in the art.

## Claims

1. A display module comprising:
a substrate;
a plurality of light-emitting device units arranged on the substrate;
barrier ribs extending from the plurality of light-emitting device units and partitioning sub-pixel regions;
a color conversion layer disposed on an upper portion of the plurality of light-emitting device units and configured to emit excitation light using light emitted from the plurality of light-emitting device units;
a common electrode including a metal layer disposed, as a portion of the plurality of light-emitting device units, on upper portions of the plurality of light-emitting device units connecting the respective light-emitting device units and inside the barrier ribs to be in contact with the upper portions of the plurality of light-emitting device units; and
a plurality of individual electrodes respectively disposed on opposite surfaces of light-emitting surfaces of the plurality of light-emitting device units.

2. The display module of claim 1, wherein the metal layer comprises a grating type according to a shape of the barrier ribs.

3. The display module of claim 1, wherein each of the plurality of light-emitting device units comprises:
a first semiconductor layer having one side integrally formed with the common electrode;
a second semiconductor layer connected to the individual electrode; and
an active layer disposed between the first semiconductor layer and the second semiconductor layer.

4. The display module of claim 3, wherein the barrier ribs extend from the common electrode.

5. The display module of claim 4, wherein a height of the metal layer is less than or equal to a height of the barrier ribs.

6. The display module of claim 1, wherein a lower end of the metal layer is disposed at a location lower than a lower end of the color conversion layer.

7. The display module of claim 6, wherein the lower end of the metal layer is disposed between the plurality of light-emitting device units and located at an upper portion of a planarization layer isolating the plurality of light-emitting device units.

8. The display module of claim 1, wherein a reflective film is formed inside the barrier ribs.

9. The display module of claim 1, wherein an optical layer is disposed at an upper portion of some of the plurality of light-emitting device units.

10. The display module of claim 9, wherein the plurality of light-emitting device units emit light of a same wavelength.

11. The display module of claim 9, further comprising a plurality of color filter layers disposed at an upper portion of the color conversion layer and an upper portion of the optical layer.

12. The display module of claim 11, further comprising:
a black matrix partitioning the plurality of color filter layers, and
wherein the black matrix is located above the barrier ribs.

13. The display module of claim 11, further comprising:
a plurality of microlenses disposed on an upper surface of the plurality of color filter layers.

14. The display module of claim 11, further comprising:
a black matrix disposed above the barrier ribs;
a thin film encapsulation layer covering the color conversion layer, the optical layer, and the black matrix;
a plurality of color filters disposed on an upper surface of the thin film encapsulation layer and corresponding to the optical layer;
a plurality of microlenses disposed on an upper surface of the plurality of color filter layers; and
a reflective layer disposed at a lower portion of the plurality of microlenses and configured to collect light emitted from the plurality of light-emitting device units to a corresponding microlens,
wherein the reflective layer comprises a plurality of openings configured to reduce an area of light emission before the light emitting from the light-emitting device units is incident on the corresponding microlens.

15. A wearable device comprising:
a display module comprising a substrate and a plurality of sub-pixels arranged on the substrate;
a projection lens configured to concentrate light emitted from the display module; and
a diffraction optical member that introduces light emitted from the projection lens at one side and emits the light to another side,
wherein the plurality of subpixels comprise:
a plurality of light-emitting device units, barrier ribs extending from the plurality of light-emitting device units and partitioning sub-pixel regions, an optical layer and a color conversion layer disposed between the barrier ribs, a plurality of color filter layers disposed on an upper portion of the color conversion layer and an upper portion of the optical layer, a black matrix partitioning the plurality of color filter layers, a plurality of microlenses disposed on an upper surface of the plurality of color filter layers, a common electrode including a metal layer disposed, as a portion of the plurality of light-emitting device units, on upper portions of the plurality of light-emitting device units connecting the respective light-emitting device units and inside the barrier ribs to be in contact with the upper portions of the plurality of light-emitting device units, and a plurality of individual electrodes respectively disposed on opposite surfaces of light-emitting surfaces of the plurality of light-emitting device units,
wherein the metal layer comprises a grating shape along a shape of the barrier ribs, and the barrier ribs extend from the common electrode.
